# EUROPÄISCHE PATENTSCHRIFT

(11) **EP 2 099 877 B1**
(45) Veröffentlichungstag und Bekanntmachung des Hinweises auf die Patenterteilung: **26.11.2014**
(21) Anmeldenummer: 07818738.2
(22) Anmeldetag: 05.10.2007
(51) Int. Cl.: C09K 13/02, C03C 15/00, H01L 21/311, H01L 31/18, C09K 3/14

(54) **PARTIKELHALTIGE ÄTZPASTEN FÜR SILIZIUMOBERFLÄCHEN UND -SCHICHTEN**
ETCHING PASTE CONTAINING PARTICLES FOR SILICON SURFACES AND LAYERS
PÂTES D'ATTAQUE CHIMIQUE CONTENANT DE PARTICULES POUR DES SURFACES DE SILICIUM ET DES COUCHES DE SILICIUM

(30) Priorität: 01.11.2006 DE 102006051952
(43) Veröffentlichungstag der Anmeldung: 16.09.2009
(73) Patentinhaber: Merck Patent GmbH, 64293 Darmstadt (DE)
(72) Erfinder: STOCKUM, Werner, 64354 Reinheim (DE); KLEIN, Sylke, 64380 Rossdorf (DE); KUEBELBECK, Armin, 64625 Bensheim (DE)
(86) Internationale Anmeldenummer: PCT/EP2007/008662
(87) Internationale Veröffentlichungsnummer: WO 2008/052636

(56) Entgegenhaltungen:
- EP-A- 1 378 947
- WO-A-2004/032218
- WO-A-2006/074791
- US-A- 5 688 366

## Beschreibung

Die vorliegende Erfindung betrifft partikelhaltige Ätzmedien in Form von Ätzpasten, welche geeignet sind zum ganzflächigen oder selektiven Ätzen von feinsten Linien oder Strukturen in Siliziumoberflächen und -schichten sowie in glasartige Oberflächen, welche aus geeigneten Siliziumverbindungen gebildet werden. Die vorliegende Erfindung betrifft auch die Verwendung der erfindungsgemäßen Pasten in Verfahren zum Ätzen solcher Oberflächen.

### Stand der Technik

Siliziumoberflächen und -schichten werden in der Photovoltaik-, Elektronik- und Halbleiterindustrie oft nasschemisch in Tauchbädern geätzt. Diese ganzflächige Ätzung kann dabei entweder im sauren (isotrope Ätzung) oder im alkalischen Medium (anisotrope Ätzung) erfolgen. Im Sauren werden häufig Mischungen von Flusssäure und Salpetersäure, im Alkalischen starke Basen wie Natronlauge, Kalilauge, Tetramethylammoniumhydroxid (TMAH), usw. verwendet.

Um neben der ganzflächigen Ätzung (z.B. Polierätze, Texturätze) definierte, feine Ätzmuster bzw. -strukturen (z.B. für vergrabene Strukturen) zu erzeugen, waren bis vor einiger Zeit vor dem eigentlichen Ätzschritt materialintensive, zeit- und kostenaufwendige Prozessschritte notwendig, wie z.B. der dem Fachmann bekannte fotolithografische Maskierungsprozess.

Bei einem solchen Maskierungsprozess geht man üblicherweise von einem Siliziumwafer aus. Auf diesem wird durch thermische Oxidation eine dichte Oxidschicht erzeugt und wie folgt strukturiert:

Durch Beschichtung mit einem Photoresist, anschließendes Trocknen, Belichten mit UV-Licht und einer Photomaske, und darauffolgendes Entwickeln, wird das Oxid an den gewünschten Stellen freigelegt und danach mit Flusssäure entfernt. Anschließend wird der noch verbleibende Photoresist beispielsweise mit einem Lösungsmittel entfernt ("gestrippt"). Der so mit einer Oxidmaske versehene Si-Wafer kann nun in einer starken Base, wie z.B. 30%ige KOH, selektiv an den Stellen geätzt werden, die nicht vom Oxid bedeckt werden. Die Oxidmaske ist gegenüber der Base beständig. Nach erfolgter selektiver Ätzung des Siliziums wird die Oxidmaske meist mit Flusssäure wieder entfernt.

Solche lithografischen Verfahren werden in der industriellen Solarzellenherstellung aus Kostengründen nicht angewendet [1]. Das selektive Strukturieren oder Öffnen der Siliziumoberfläche bzw. -schicht ist jedoch auch im geänderten Herstellungsprozess notwendig.

Während der Herstellung einer Standard-Siliziumsolarzelle wird beispielsweise durch eine Gasdiffusion im POCl₃-Ofen auf einem p-dotierten Wafer der für den fotoelektrischen Effekt notwendige p-n-Übergang gebildet. Dabei entsteht um den gesamten Wafer eine ca. 500 nm dicke, n-dotierte Siliziumschicht, die für die spätere fotovoltaische Anwendung partiell geöffnet bzw. aufgetrennt werden muss.

Diese Öffnung kann mechanisch durch Laser-cutting erfolgen oder in einem Trockenätzverfahren, wie durch Plasmaätzen.

Nachteile der mechanischen Auftrennung, z.B. des Abschleifens der Zellkanten im letzten Schritt des Herstellprozesses (nach der Metallisierung), gehen mit erheblichen Materialverlusten an Silizium (und Metallpaste) einher, erzeugen mechanischen Stress und rufen gegebenenfalls Kristalldefekte in der Solarzelle hervor.

Das Plasmaätzen erfolgt mit fluorierten Kohlenwasserstoffen, z.B. mit CF₄- oder C₂F₆- Gas in teuren Vakuumanlagen. Dabei werden die Zellen vorher gestapelt und in der Plasmaätzanlage an den Zellkanten geätzt. In diesem Prozess kommt es häufig zu erheblichen Handhabungsproblemen beim Stapeln und zu hohen Wafer-Bruchraten. Diese technologischen Probleme werden sich zukünftig noch verschärfen, da man bestrebt ist, auf Grund hoher Materialkosten immer dünnere polykristalline Silizium-Ausgangssubstrate (< 200 µm) gegenüber den heute üblichen Substratdicken von 250-330 µm zu verwenden.

Das Auftrennen des p-n-Übergangs per Laser ist, bedingt durch die notwendige lineare (XY) Bewegung der punktförmigen Laser-Quelle, ein zeitaufwendiges, den Durchsatz limitierendes Verfahren. Die Investitionskosten hierfür sind erheblich. Zudem werden lokale Kristalldefekte erzeugt.

In den gegenwärtig nur im Labormaßstab entwickelten und angewendeten teuren Verfahren zur Erzeugung eines selektiven Emitters wird die bereits oben beschriebene lithografische Oxidmaskierung angewendet. Das Oxid maskiert den Wafer so, dass die Bereiche, auf denen später die Kontakte liegen, frei bleiben. Der maskierte Wafer wird einer Phosphordiffusion unterzogen und in den nicht maskierten Bereichen n⁺⁺-dotiert. Nach der Entfernung der Oxidmaske wird der gesamte Wafer n⁺-dotiert [2].

Dadurch erhält man eine Solarzelle mit selektivem Emitter, d.h. mit 2 - 3 µm tiefen, hochdotierten n⁺⁺-Bereichen (Bereiche ohne Oxidmaske und später unter den Kontakten liegend) einer Dotierkonzentrationen von ca. 1*10²⁰ cm⁻³ und einem flachen (0.5-1 µm) n⁺-dotierten Emitter über die gesamte Solarzelle mit einer Dotierkonzentration von ca. 1*10¹⁹ cm⁻³.

Eine Alternative zur Lithografiemethode besteht in der Nutzung von siebgedruckten Kontaktlinien als Ätzmaske. Zur ihrer Herstellung wird in der Literatur sowohl das nasschemische als auch das plasmachemische Ätzen beschrieben. Nachteilig sind beim Dip (Tauchen) der siebgedruckten Solarzelle in eine Mischung aus HF/HNO₃ - neben dem beabsichtigten Siliziumabtrag zwischen den Kontaktlinien - der Angriff des Siliziums unter den Kontaktlinien und die möglicherweise entstehenden Ätzschäden in den Metallkontaktlinien selbst. Dadurch kommt es zur rapiden Verschlechterung des Füllfaktors [3].

Das plasmachemische Ätzen (Reactive Ion Etching, RIE) erfolgt mit Gasen wie z.B. SF₆ bzw. SF₆/O₂ in teuren Vakuumanlagen und unter erheblichen technologischen Optimierungsaufwand des Prozesses [4], [5], [6].

Neben der Bildung des selektiven Emitters wird dabei die Siliziumoberfläche auf der Emitterseite so strukturiert (aufgerauht, "texturiert"), dass sich das Antireflexionsverhalten der Solarzelle verbessert.

Zur Optimierung des Verfahrens zur Herstellung von Halbleiterstrukturen wurden in den letzten Jahren druckbare Ätzmedien mit nicht-Newtonschen Fließverhalten entwickelt, die es ermöglichen im Produktionsprozess aufwändige Maskierungsschritte einzusparen. Ursprünglich wurden zu diesem Zweck partikelfreie Zusammensetzungen eingesetzt. In WO 2006/074791A wurden dagegen partikelhaltige, druckfähige Ätzmedien mit nicht-Newtonschen Fließverhalten beschrieben, die sich zum selektiven Ätzen von feinsten Strukturen und Linien in Oberflächen eignen und in der Herstellung von Solarzellen einsetzbar sind. Es handelt sich dabei um Ätzmedien, in denen Phosphorsäure oder Phosphorsäuresalze nach Aktivierung durch Hitze als Ätzkomponenete wirken. Als Partikel werden organische Polymerpartikel mit einem relativen Durchmesser von 10 bis 30 µm eingesetzt, welche mit den übrigen Komponenten der Zusammensetzung in Wechselwirkung treten und auf molekularer Ebene ein Netzwerk ausbilden, so dass eine Erhöhung der Viskosität eintritt.

Aus US 5,688,366 A sind Ätzpastenzusammensetzungen für die Verwendung in der Halbleitertechnologie bekannt, welche zur Erhöhung der Viskosität partikuläre Zusätze enthalten. Bei den zugesetzten Partikel handelt es sich um Polymerpartikel, die so ausgewählt sind, dass sie sich weder in der makromolekularen Struktur während des Ätzens bei erhöhter Temperatur ändern noch mit den Inhaltsstoffen der Paste reagieren. Weiterhin haben diese Partikel einen Schmelzpunkt, der oberhalb der Temperatur liegt, bei der der Ätzschritt erfolgt. Als Ätzkomponente dient in diesen Zusammensetzungen vorzugsweise Eisen(III)chlorid.

Aus WO 2004/032218 A1 ist ein vereinfachtes Verfahren bekannt, wobei in den Wafer-Oberflächen feinste Linien oder Strukturen durch Einwirkung von selektiv aufgedruckten alkalischen Ätzpasten erzeugt werden. Bei den verwendeten Pasten handelt es sich um partikelfreie Zusammensetzungen, in denen beispielsweise KOH bzw. NaOH als Ätzkomponenten wirken. Nachteil dieser Kalium- oder Natriumhydroxid enthaltenden Ätzpasten ist die starke Hygroskopizität. Dadurch wird die Paste in der Zeit zwischen ihrem Auftrag auf und ihrer Entfernung von der zu ätzenden Oberfläche durch Aufnahme von Feuchtigkeit aus der Umgebungsluft mehr oder weniger verdünnt. Mit zunehmender Ätzdauer wird die Ätzkraft der Paste stetig geschwächt. Gleichzeitig nimmt die Viskosität der Paste durch die aufgenommene Flüssigkeit ab und die aufgedruckten Pasten in Form von Linien oder Strukturen zerfließen. Mit zunehmender Einwirkzeit verbreitern sich durch diesen Effekt aufgedruckte Linien. Die sich verflüssigenden und zerfließenden Pasten runden die Ätzgrabenflanken und ätzen zuvor intakte Oberflächen an. Gleichzeitig ist die maximal zu erreichende Ätztiefe durch die stetige Verdünnung begrenzt. Auch können mit den bekannten Kaliumhydroxid-haltigen Pasten nur reine Silizium-Oberflächen mit ausreichender Geschwindigkeit in einem technischen Prozess strukturiert werden. Dagegen müssen bisher Mehrschichtsysteme, welche aus reinen Siliziumschichten und Schichten aus Siliziumderivaten bestehen, beispielsweise aus Phosphatsilikatglas, in aufeinanderfolgenden Schritten nacheinander mit verschiedenen Pastentypen geätzt werden.
[1] W. Wettling, Phys. BI. 12 (1997), S.1197-1202
[2] J. Horzel, J. Slufzik, J. Nijs, R. Mertens, Proc. 26th IEEE PVSC, (1997), S. 139-42
[3] M. Schnell, R. Lüdemann, S. Schäfer, Proc. 16th EU PVSEC, (2000), S. 1482-85
[4] D.S. Ruby, P. Yang, S. Zaidi, S. Brueck, M. Roy, S. Narayanan, Proc. 2nd World Conference and Exhibition on PVSEC, (1998), S. 1460-63
[5] US 6,091,021 (2000), D.S. Ruby, W.K. Schubert, J.M. Gee, S.H. Zaidi
[6] US 5,871,591 (1999), D.S. Ruby, J.M. Gee, W.K. Schubert
[7] EP 0229915 (1986), M. Bock, K. Heymann, H.-J. Middeke, D. Tenbrink
[8] WO 00/40518 (1998), M. Luly, R. Singh, C. Redmon, J. Mckown, R. Pratt
[9] DE 10101926 (2000), S. Klein, L. Heider, C. Zielinski, A. Kübelbeck, W. Stockum
[10] A.F. Bogenschütz, Ätzpraxis für Halbleiter, Carl Hanser Verlag, München 1967
[11] WO 2004/032218 A1,

### Aufgabenstellung

Die Aufgabe der vorliegenden Erfindung ist es daher, ein entsprechendes einfaches und kostengünstiges Verfahren sowie eine darin einsetzbare Ätzpaste zur Verfügung zu stellen, wodurch die oben geschilderten Nachteile und Probleme vermieden werden können und durch das Siliziumoberflächen selektiv zur Erzeugung von Emittern und zur Verbesserung des Antireflexionsverhaltens geätzt werden können.

### Beschreibung der Erfindung

Die Aufgabe wird insbesondere durch die Bereitstellung eines Ätzmediums zum Ätzen von Siliziumoberflächen und -schichten in Form einer verdickten, pastenförmigen, alkalischen Zusammensetzung erfüllt, das neben geeigneten Verdickern feinste, niedrig schmelzende Polymerpartikel enthält, das in einem Verfahren gemäß Anspruch 1 eingesetzt wird.

Solche partikelhaltigen, alkalischen Zusammensetzungen sind kostengünstig herzustellen. Sie lassen sich schnell und selektiv, beispielsweise mit einem Siebdrucker oder einem Dispenser, auf die zu ätzenden Stellen aufbringen. Im Anschluss an das Aufdrucken der Paste in Form von feinsten Linien und Strukturen erfolgt der gewünschte Ätzprozess bevorzugt bei erhöhten Temperaturen. Hierbei wirken überraschenderweise die enthaltenen Partikel stabilisierend auf die Formen der aufgedruckten Linien und Strukturen der Ätzpasten.

Neben dem beschriebenen Öffnen der p-n-Übergänge einer Solarzelle erfolgt durch das selektive Ätzen von Silizium mit den erfindungsgemäßen Ätzpasten die Erzeugung von selektiven (auch zweistufigen) Emittern in der Massenproduktion. Gleichzeitig wird durch die Verwendung der neuen Ätzpasten eine Verbesserung des Antireflexionsverhaltens der Solarzelle ermöglicht, wobei ein Unterätzen der Siliziumschichten an Stegen, Kanten und in Ätzgräben eingedämmt bzw. vermieden werden kann.

Die vorliegende Erfindung umfasst somit ein druckfähiges und dispensierfähiges alkalisches Ätzmedium in Form einer partikelhaltigen Ätzpaste, welche
a)Wenigstens eine basische Ätzkomponente
b) mindestens ein Lösungsmittel
c) feinste organische Partikel mit niedriger Schmelztemperatur und gegebenenfalls anorganische Partikel,
d)gegebenenfalls Verdickungsmittel und
e) gegebenenfalls Additive wie Entschäumer, Thixotropiermittel, Verlaufsmittel, Entlüfter, Haftvermittler enthält,
das in einem Verfahren zum Ätzen von Siliziumoberflächen und - schichten oder glasartigen Oberflächen, bestehend aus einem Siliziumderivat selektiv auf die Oberfläche aufgebracht wird und während der Einwirkzeit auf eine Temperatur höher als 70°C, jedoch niedriger als 200° erhitzt wird.

Dieses Ätzmedium ist im erfindungsgemäßen Verfahren bei Temperaturen höher als 70 °C wirksam, vorzugsweise ist es bei Temperaturen oberhalb von 150 °C, jedoch niedriger als 200 °C, einsetzbar, wobei enthaltene niedrig schmelzende Partikel des enthaltenen Polymerpulvers, ausgewählt aus der Gruppe der Polyethylen-, Polypropylen oder entsprechender Mischpulver mit niedrigem Schmelzpunkt unterhalb von 150°C aufschmelzen und sich im geschmolzenen Zustand nicht mit den übrigen Komponenten der Ätzpaste mischen, sondern ein Zweiphasensystem bilden und auf dem Ätzmedium eine dünne Polymerschicht bilden.

Erfindungsgemäße Ätzmedien enthalten als ätzende Komponente eine organische oder anorganische Base, bevorzugt mindestens eine Komponente ausgewählt aus der Gruppe Natriumhydroxid, Kaliumhydroxid, Ammoniak, Ethanolamin, Ethylendiamin, Tetraalkylammoniumhydroxid oder ein Gemisch dieser Basen. Einsetzbar sind auch Gemische wie beispielsweise Ethylendiamin/ Brenzcatechin, Ethanolamin/Gallussäure. Bevorzugt werden jedoch Basen aus der erstgenannten Gruppe zu diesem Zweck verwendet. Insbesondere bevorzugt werden Natriumhydroxid und/oder Kaliumhydroxid als Ätzkomponenten in den Zusammensetzungen verwendet. Dementsprechend enthalten erfindungsgemäße Ätzmedien als ätzende Komponente vorzugsweise NaOH und/oder KOH, in einer Konzentration von 2 bis 50 Gew.-%, vorzugsweise 5 bis 48 Gew.-%, bezogen auf die Gesamtmenge.

Ein wesentlicher Bestandteil der erfindungsgemäßen Pasten, durch den das Ätzergebnis vorteilhaft beeinflusst wird, sind feinpartikuläre Pulver. Dieses können sowohl anorganische als auch organische Pulver sein. Vorzugsweise handelt es sich dabei um organische Polymerpulver mit niedriger Schmelztemperatur. Als besonders geeignet haben sich Polyolefinpulver erwiesen, und zwar insbesondere Polyethylen-, Polypropylen- oder entsprechende Mischpolymerpulver. Insbesondere Polymerpulver mit einem Schmelzpunkt unterhalb von 150 °C führen in der Verwendung der Pasten zu besonders guten Ergebnissen. Zur Herstellung der Pasten können entsprechende Polymerpulver bezogen auf die Gesamtmenge der Zusammensetzung in einer Menge von 1 bis 50 Gew.-%, bevorzugt in einer Menge im Bereich von 10 bis 50 Gew.-%, zugesetzt werden. Durch Versuche wurde gefunden, dass sowohl das Aufdrucken der Pasten in Form sehr dünner Linien oder feinster Strukturen mit gutem Ergebnis möglich ist, wenn die Partikel der verwendeten Polymerpulver relative Partikeldurchmesser im Bereich von 10 nm bis 30 µm aufweisen. Besonders gute Druckergebnisse werden bei Verwendung von Pulvern mit relativen Partikeldurchmessern von 1 bis 10 µm erzielt und wenn die Viskosität der Paste in einem geeigneten Bereich liegt. Sehr gut verdrucken lassen sich die Pasten, wenn sie eine Viskosität im Bereich von 20 bis 40 Pas besitzen. Bevorzugt wird mit solchen Ätzpasten gearbeitet, die eine Viskosität im Bereich von 25 bis 35 Pas aufweisen.

Weiterhin kann ein Teil der organischen Polymerpulver durch anorganische feinpartikuläre Pulver ersetzt sein. Bevorzugt können als anorganische Pulver feinster Graphit oder feinstes Rußpulver zugesetzt werden.

Die erfindungsgemäßen Ätzmedien können als Lösungsmittel solche ausgewählt aus der Gruppe Wasser, iso-Propanol, Diethylenglykol, Dipropylenglykol, Polyethylenglykole,1,2-Propandiol, 1,4-Butandiol, 1,3-Butandiol, Glycerin, 1,5-Pentandiol, 2-Ethyl-1-hexanol oder deren Gemische enthalten, oder Lösungsmittel ausgewählt aus der Gruppe Acetophenon, Methyl-2-hexanon, 2-Octanon, 4-Hydroxy-4-methyl-2-pentanon, 1-Methyl-2-pyrrolidon, Ethylenglycolmonobutylether, Ethylenglycolmonomethylether, Triethylenglykolmonomethylether, Diethylenglykolmonobuthylether, Dipropylenglykolmonomethylether, Carbonsäureester wie [2,2-Butoxy-(Ethoxy)]-Ethylacetat, Propylencarbonat rein oder im Gemisch oder Gemische, die sowohl Lösungsmittel der ersten als auch der zweiten Gruppe enthalten. Üblicherweise sind in den erfindungsgemäßen Ätzmedien Lösungsmittel in einer Menge von 10 bis 90 Gew.-%, vorzugsweise in einer Menge von 15 bis 85 Gew.-%, bezogen auf die Gesamtmenge des Mediums enthalten.

Weiterhin kann in den erfindungsgemäßen Ätzmedien ein Verdickungsmittel ausgewählt aus der Gruppe Hydroxylalkylguar, Xanthan Gum, Cellulose und/oder Ethyl-, Hydroxylpropyl-, Hydroxylethylcellulose, Carboxymethylcellulose, Natrium-Carboxymethyl-hydroxylethylcellulose, Homopolymere oder Copolymere auf der Basis funktionalisierter Vinyleinheiten der Acrylsäure, Acrylate, und Alkylmethacrylate (C₁₀-C₃₀) einzeln oder im Gemisch in einer Menge von 0,5 bis 25 Gew.-%, vorzugsweise 1 bis 10 Gew.-% bezogen auf die Gesamtmenge des Ätzmediums enthalten sein.

Neben diesen Komponenten können Additive, ausgewählt aus der Gruppe Entschäumer, Thixotropiermittel, Verlaufsmittel, Entlüfter, und Haftvermittler in einer Menge von 0 bis 2 Gew.-%, bezogen auf die Gesamtmenge enthalten sein.

Additive mit für den gewünschten Zweck vorteilhaften Eigenschaften sind beispielsweise im Handel erhältliche
Entschäumer, wie z. B. TEGO® Foamex N,
Thixotropiermittel, wie BYK® 410, Borchigel® Thixo2,
Verlaufsmittel, wie TEGO® Glide ZG 400,
Entlüfter, wie TEGO® Airex 985 oder
Haftvermittler, wie Bayowet® FT 929.
Weitere Additive sind in der folgenden ausführlichen Beschreibung der Erfindung genannt. Es versteht sich für den Fachmann von selbst, dass diese Additive auch durch andere im Handel erhältliche, gleichwirkende Produkte ersetzt werden können. Wesentlich ist in diesem Zusammenhang, dass durch die Zugabe solcher Additive die Produkteigenschaften verbessert werden.
Speziell in durchgeführten Versuchen eingesetzte Additive sind auch aus den im folgenden gegebenen Beispielen zu entnehmen. Diese können die Druckfähigkeit der Ätzpaste positiv beeinflussen.

Gegenstand der vorliegenden Erfindung ist insbesondere ein Verfahren zum selektiven Ätzen von Siliziumoberflächen und - schichten, in welchem das Ätzmedium ganzflächig oder selektiv gemäß einer Ätzstrukturvorlage gezielt nur an den Stellen der Oberfläche aufgetragen wird, an denen eine Ätzung erwünscht ist. Nach der gewählten Einwirkzeit von 30 s bis 5 min bei einer Temperatur oberhalb des Schmelzpunkts der in der Ätzpaste enthaltenen Pulverpartikel wird das Ätzmedium wieder entfernt wird.

Erfindungsgemäß wirkt das Ätzmedium bei einer Temperatur im Bereich von höher 80 °C bis etwa 150 °C, vorzugsweise höher, jedoch bei Temperaturen niedriger als 200 °C, ein. Die Einwirktemperatur wird bevorzugt auf eine Temperatur höher als die Schmelztemperatur der zugesetzten Polymerpartikel, vorzugsweise höher als 150 °C, aber möglichst nicht höher als auf 200 °C eingestellt. Die Aktivierung und Einstellung der Temperatur erfolgt vorzugsweise durch Energieeintrag, besonders bevorzugt durch IR-Strahlung.

Im erfindungsgemäß beanspruchten Verfahren wird das Ätzmedium durch ein Sieb-, Schablonen-, Tampon-, Stempel-, Ink-Jet- oder manuelles Druckverfahren oder in einer Dispensiertechnik auf die zu ätzende Oberfläche aufgebracht. Nach der Einwirkzeit und erfolgter Ätzung wird das Ätzmedium mit Wasser oder einem anderen Lösungsmittel oder mit einem Lösungsmittelgemisch abgespült.

Die erfindungsgemäßen Ätzmedien können in Herstellungsprozessen der Photovoltaik, Halbleitertechnik, Hochleistungselektronik oder Displayherstellung verwendet werden, insbesondere in Verfahren zur Herstellung von Photodioden, Schaltkreisen, elektronischen Bauelementen oder in Verfahren zum Ätzen von Siliziumoberflächen und -schichten zur Trennung des p-n Übergangs in Solarzellen. Sie können zudem in Verfahren verwendet werden zum Ätzen von Siliziumoberflächen und -schichten zur Herstellung eines selektiven Emitters für Solarzellen, zum Ätzen von Siliziumoberflächen und -schichten von Solarzellen zur Verbesserung des Antireflexionsverhaltens, zum Ätzen von Siliziumoberflächen und -schichten in einem Verfahren zur Herstellung von Halbleiterbauelementen und deren Schaltkreisen, oder zum Ätzen von Siliziumoberflächen und -schichten in einem Verfahren zur Herstellung von Bauelementen der Hochleistungselektronik.

### Gegenstand der Erfindung

Gegenstand der Erfindung ist es, Halbleiteroberflächen und -schichten, insbesondere Siliziumoberflächen und -schichten mit Ätzpasten ganzflächig oder selektiv zu ätzen oder zu strukturieren. Eine für die Übertragung der Ätzpaste auf die zu ätzende Fläche geeignete Technik mit hohem Automatisierungsgrad und Durchsatz ist die Druck- und Dispensiertechnik. Insbesondere die Sieb-, Schablonen-, Tampon-, Stempel-, Ink-Jet-Druckverfahren und das Dispensierverfahren sind dem Fachmann bekannt. Ein manuelles Auftragen, z. B. mit einem Pinsel oder einer Auftragrolle, ist ebenfalls möglich.

In Abhängigkeit von der Sieb-, Schablonen-, Klischee-, Stempelgestaltung bzw. Patronen- oder Dosiergerät-Ansteuerung ist es möglich, die erfindungsgemäß beschriebenen Ätzpasten ganzflächig bzw. gemäß der Ätzstrukturvorlage selektiv nur an den Stellen aufzutragen, an de-
- feinteilige, niedrig schmelzende organische Pulver und gegebenenfalls feinteilige anorganische Pulver
- gegebenenfalls Additive wie z.B. Entschäumer, Thixotropiermittel, Verlaufsmittel, Entlüfter, Haftvermittler

Um die Halbleiterelemente der 4. Hauptgruppe des Periodensystems wie Silizium zu ätzen, werden erfindungsgemäß starke Laugen verwendet [7]. Die Ätzwirkung der erfindungsgemäß beschriebenen Ätzpasten beruht daher auf dem Einsatz von alkalischen, Silizium-ätzenden Lösungen.

In den erfindungsgemäß beschriebenen Ätzpasten können als alkalische Ätzkomponenten wässrige Lösungen aus anorganischen Laugen wie Natriumhydroxid, Kaliumhydroxid, Ammoniak oder organisch basierende, alkalische Ätzmischungen wie Ethylendiamin/Brenzcatechin, Ethanolamin/Gallussäure, Tetraalkylammoniumhydroxid oder Kombinationen aus beiden verwendet werden. Besonders bevorzugt sind solche Zusammensetzungen, die lediglich Natriumhydroxid und/oder Kaliumhydroxid enthalten. Ganz besonders bevorzugt sind Zusammensetzungen in denen Natriumhydroxid als Ätzkomponente enthalten ist. Besonders gute Ätzergebnisse werden auch erhalten, wenn Natriumhydroxid und Kaliumhydroxid gemeinsam in einem geeigneten Mischungsverhältnis eingesetzt werden. Dieses Mischungsverhältnis liegt vorteilhafter weise etwa bei einem Verhältnis von KOH zu NaOH von 2 : 1. Dieses Verhältnis kann auch etwas nach oben oder nach unten verschoben sein.

Der Anteil der eingesetzten Ätzkomponenten liegt in einem Konzentrationsbereich von 2 - 50 Gew.-%, bevorzugt 5 - 48 Gew.-%, bezogen auf die Gesamtmasse der Ätzpaste. Besonders bevorzugt sind solche Ätzmedien, in denen die Ätzkomponenten in einer Menge von 10 - 45 Gew.-% enthalten sind. Insbesondere geeignet sind Ätzmedien, in denen die Ätzkomponente(n) in einer Menge von 30 - 40 Gew.-%, bezogen auf die Gesamtmasse der Ätzpaste enthalten ist (sind), da für solche Ätzmedien Ätzraten gefunden wurden, die eine vollständige Öffnung des p-n Übergangs ermöglichen und Halbleiterelemente mit einem hohen Durchsatz behandelt werden können. Gleichzeitig zeigen diese Ätzpasten eine hohe Selektivität gegenüber den zu ätzenden Oberflächenschichten.

Die Ätzkomponenten sind in den Ätzpasten bereits bei 70 - 150 °C wirksam. Durch Versuche wurde jedoch gefunden, dass verbesserte Ätzergebnisse erzielt werden, wenn während des Ätzvorgangs schnell auf Temperaturen knapp oberhalb des Schmelzpunkts der enthaltenen Polymerpartikel erhitzt wird, so dass bevorzugt bei Temperaturen oberhalb von 150°C gearbeitet wird. Vorzugsweise erfolgt daher das Ätzen mit den erfindungsgemäßen Ätzmedien bei Temperaturen unterhalb von 200 °C.

Wie bereits oben gesagt, können den Ätzpasten sowohl anorganische als auch organische Pulver, vorzugsweise organische Polymerpulver, zugesetzt sein. Es kann sich dabei um feinstpartikuläre Pulver, aus Polymeren ausgewählt aus der Gruppe Polystyrol, Polyacryl, Polyamid, Polyimid, Polymethacrylat, Melamin-, Urethan- , Benzoguanine-, Phenolharz, Siliconharz, fluorierte Polymere (PTFE, PVDF u. a.), oder Polyolefine, wie Polyethylen oder Polypropylen, und mikronisiertes Wachs handeln, welche sich im geschmolzenen Zustand nicht mit den übrigen Komponenten der Ätzpaste mischen, sondern ein Zweiphasensystem bilden. Als anorganische Pulverzusätze kommen insbesondere solche in Frage, die sich in Gegenwart von starken Basen, die als Ätzkomponenten eingesetzt werden, inert verhalten. Vorzugsweise lassen sich daher feinste Graphit- oder Rußpulver für diesen Zweck einsetzen.

Als besonders geeignet für diese Verwendung haben sich Polyolefinpulver erwiesen, und zwar insbesondere Polyethylen-, Polypropylen- oder entsprechende Mischpolymerpulver. Für diesen Zweck können verschiedene feinst partikuläre Polyethylenpulver geeignet sein. Es können sowohl LD-PE-Pulver als auch HD-PE-Pulver in den Pasten eingesetzt werden. Wesentlich ist in diesem Zusammenhang die Schmelztemperatur der Polymere und die Tatsache, dass sich beim schnellen Aufschmelzen ein Zweiphasensystem aus der Pastenzusammensetzung bildet.

Insbesondere Polymerpulver mit einem Schmelzpunkt unterhalb von 150 °C führen in der Verwendung der Pasten zu besonders guten Ergebnissen. Zur Herstellung der Pasten können entsprechende Polymerpulver bezogen auf die Gesamtmenge der Zusammensetzung in einer Menge von 1 bis 50 Gew.-%, bevorzugt in einer Menge im Bereich von 10 bis 50 Gew.-%, zugesetzt werden.

Durch Versuche wurde gefunden, dass sowohl das Aufdrucken der Pasten in Form sehr dünner Linien oder feinster Strukturen mit gutem Ergebnis möglich ist, wenn die Partikel der verwendeten Polymerpulver relative Partikeldurchmesser im Bereich von 10 nm bis 30 µm aufweisen. Besonders gute Druckergebnisse werden bei Verwendung von Pulvern mit relativen Partikeldurchmessern von 1 bis 10 µm erzielt und wenn die Viskosität der Paste in einem geeigneten Bereich liegt.

Weiterhin wurde gefunden, dass in Zusammensetzungen in denen sowohl organische Polymerpartikel als auch anorganische Partikel enthalten sind, eine Gesamtpartikelmenge von 50 Gew.-% bezogen auf die Gesamtzusammensetzung nicht überschritten werden sollte. Gleichzeitig muss der Gehalt an schmelzbaren Partikeln so hoch sein, dass sich beim Erhitzen oberhalb der Schmelztemperatur der Polymerpartikel auf der aufgedruckten Paste eine geschlossene Polymerschicht an der Oberfläche bildet, die die Paste nach außen hin abschließt. Im günstigsten Fall wird dieses erreicht, wenn in der Pastenzusammensetzung mindestens 1 Gew.-% organische Polymerpartikel, bezogen auf die Gesamtzusammensetzung enthalten sind. Vorteilhafte Bedingungen liegen vor, wenn der Gehalt an organischen Polymerpartikeln höher ist. Vorzugsweise wird daher mit Pastenzusammensetzungen gearbeitet, worin der Gehalt an organischen Polymerpartikeln mindestens 2 Gew.-% bezogen auf die Gesamtzusammensetzung beträgt, auch wenn in der Paste anorganische Partikel enthalten sind.

Zur Herstellung der erfindungsgemäßen Ätzpasten eignen sich folgende anorganische oder organische Lösungsmittel, die rein oder im Gemisch verwendet werden können:
- Wasser
- einfache oder mehrwertige Alkohole (z.B. iso-Propanol, Diethylenglykol, Dipropylenglykol, Polyethylenglykole, 1,2-Propandiol, 1,4-Butandiol, 1,3-Butandiol, Glycerin, 1,5-Pentandiol, 2-Ethyl-1-hexanol) oder deren Gemische
- Ketone (z.B. Acetophenon, Methyl-2-hexanon, 2-Octanon, 4-Hydroxy-4-methyl-2-pentanon, 1-Methyl-2-pyrrolidon)
- Ether (z.B. Ethylenglycolmonobutylether, Ethylenglycolmonomethylether, Triethylenglykolmonomethylether, Diethylenglykolmonobuthylether, Dipropylenglykolmonomethylether)
- Carbonsäureester (z.B. [2,2-Butoxy-(Ethoxy)]-Ethylacetat)
- Ester der Kohlensäure (z.B. Propylencarbonat)

So können Wasser und die genannten Alkohole rein oder im Gemisch eingesetzt werden. Es können aber auch Ketone, Ether, Carbonsäureester und Ester der Kohlensäure rein oder im Gemisch als Lösungsmittel eingesetzt werden. Unter bestimmten Bedingungen kann es auch sinnvoll sein, andere Gemische von Lösungsmittel, ausgewählt aus den verschiedenen Gruppen einzusetzen.

Bevorzugt werden Wasser und Lösungsmittel aus der Gruppe der Ether und Ketone eingesetzt.

Als besonders gut geeignet hat sich Wasser erwiesen.

Der Anteil der Lösungsmittel in der Gesamtzusammensetzung kann im Bereich von 10 - 90 Gew.-%, bevorzugt bei 15 - 85 Gew.- %, bezogen auf die Gesamtmasse der Ätzpaste liegen. Als besonders geeignet haben sich Zusammensetzungen erwiesen, in denen Lösungsmittel in einer Menge von 55 - 75 Gew.-% bezogen auf die Gesamtmasse der Ätzpaste enthalten sind.

Die Viskosität der erfindungsgemäß beschriebenen Ätzpasten wird durch netzwerkbildende, in der flüssigen Phase quellende Verdickungsmittel eingestellt und lässt sich je nach gewünschtem Einsatzgebiet variieren. Besonders gute Ätzergebnisse werden erzielt, wenn die Viskosität der hergestellten Ätzpaste in einem Bereich von 20 bis 40 Pas liegt. Bevorzugt wird mit solchen Ätzpasten gearbeitet, die eine Viskosität im Bereich von 25 bis 35 Pas aufweisen.

Die Bestimmung der Viskosität kann mit einem Brookfield-Rotationsviskosimeter erfolgen. Zu diesem Zweck werden bei Raumtemperatur (25 °C) mit einer Spindel (Nr. 7) die Viskositätskurven bei 5 Umdrehungen pro Minute und bei ansonsten gleichen Bedingungen bei unterschiedlichen Umdrehungen bis zu 50 Umdrehungen pro Minute die Viskosität gemessen. Genauer lässt sich die Viskosität mit einem Kegel-Platte-Rheometer, z. B. einem Gerät der Firma Haake (Haake RotoVisco 1) oder Thermo Electron Corporation bestimmen.

Zur Messung befindet sich die Probe in einem Scherspalt zwischen einem sehr flachen Kegel und einer koaxialen Platte. Durch die Wahl des Kegelwinkels wird eine gleichmäßige Schergeschwindigkeitsverteilung im Meßspalt erzeugt. Die Steuerung erfolgt über Drehzahl (CSR) oder Drehmoment (CSS). Gemessen wird entsprechend Drehzahl bzw. Drehmoment. Durch Kraftaufnehmer an der Antriebswelle bzw. an der Kegelunterseite kann eine Ableitung der Normalspannungen erfolgen. Im vorliegenden Fall wurde als Messsystem ein CP 2/35 System verwendet, wobei der Kegel einen Durchmesser von 35 mm und einen Winkel von 2° hat. Zur Messung wird jeweils eine Probe mit 2,5 g eingesetzt. Die Messung der Viskositätskurve erfolgt automatisch mikroprozessorgesteuert bei einer Temperatur von 23 °C mit einer Schergeschwindigkeit im Bereich von 10 - 75 s⁻¹. Der Durchschnittsmesswert ergibt sich aus 20 Messungen. Als Standardwert wird ein Wert bei einer Schergeschwindigkeit von 25 s⁻¹ ermittelt. Entsprechende Messverfahren sind in den Normvorschriften DIN 53018 und ISO 3210 genauer beschrieben.

Falls gewünscht, kann die Viskosität durch Zugabe von Lösungsmittel, im einfachsten Fall durch Zugabe von Wasser, und/oder anderen flüssigen Komponenten und/oder sonstigen Viskositätshilfsstoffen eingestellt werden.

Die erfindungsgemäßen Pasten sollten eine Viskosität in einem Bereich von 20 bis 40 Pas aufweisen, um beispielsweise beim Siebdruck einen gleichmäßigen Fluss durch das Sieb während des Aufdruckens zu gewährleisten. Da die erfindungsgemäßen Pasten thixotrope Eigenschaften aufweisen, verringert sich die Viskosität bei Einwirkung von Scherkräften, so dass für eine spezielle Zusammensetzung die Viskosität in einem bestimmten Bereich variiert.

Insbesondere der Zusatz von anorganischem Graphit- oder Rußpulver mit relativen Partikeldurchmessern von weniger als 80 nm, insbesondere von weniger als 50 nm, bevorzugt von 45 nm bis 30 nm, und einer spezifischen BET Oberfläche im Bereich von 40 bis 100 m²/g, bevorzugt von 50 bis 70 m²/g, führt zu verbesserten Ergebnissen. Ganz besonders bevorzugt ist die Verwendung von Rußpulvern mit Partikeldurchmessern von etwa 40 nm und von einer spezifischen BET Oberfläche von etwa 62 m²/g. So führt die Verwendung von solchen Pulvern mit einem relativen Partikeldurchmesser von etwa 40 nm und einer spezifischen BET Oberfläche von etwa 62 m²/g zu Zusammensetzungen mit verbesserten Umwelteigenschaften, und zwar wurde gefunden, dass der Gesamtpulverzusatz erheblich reduziert werden kann zur Herstellung einer Paste mit einer Viskosität von weniger als 40 Pas, insbesondere von etwa 30 Pas.

Zur Herstellung der erfindungsgemäßen Pasten können im Handel erhältliche Graphit- bzw. Rußpulver verwendet werden, welche die oben beschriebenen Eigenschaften aufweisen und die Größen- und Oberflächenanforderungen erfüllen. Beispielhaft sei hier das käufliche Produkt Super P^{™} (conductive Carbon Black, der Firma TIMCAL Graphite & Carbon, Schweiz) genannt.

Durch Verwendung von Rußpartikeln lässt sich die Verwendungsdauer der zur Entfernung von Schwebstoffteilchen aus dem Abwasser erforderlichen Abwasserfilter, erheblich verlängern, und zwar zur Entfernung der Schwebstoffteilchen aus dem Abwasser, das bei den Spülvorgängen zur Reinigung der geätzten Oberflächen anfällt.

Überraschenderweise wurde durch Messungen gefunden, dass die abgespülten Rußpartikel (aktiver Kohlenstoff) eine adsorptive Wirkung gegenüber den organischen Verdickerzusätzen und organischen Lösemittelanteilen der Paste besitzen. Dieses hat zur Folge, dass sich der BSB5 Wert (mg/l) im Spülwasser durch einfache Partikelfiltration reduzieren lassen kann. Bei dem BSB5-Wert handelt es sich um den Biologischen Sauerstoffbedarf (mg/l) von Abwasser in 5 Tagen, gemessen nach DIN 38409 H51.

Zur Bestimmung der Partikelgrößen, sowohl der anorganischen als auch der organischen Polymerpartikel, können allgemein übliche Methoden eingesetzt werden. Beispielsweise kann die Partikelgröße mittels Partikelkorrelations-spektroskopie (PCS) ermittelt werden, wobei die Untersuchung mit einem Malvern Zetasizer nach Bedienungsanleitung durchgeführt wird. Dabei wird der Durchmesser der Partikel als d₅₀- oder d₉₀-Wert bestimmt. Die angegebenen Partikeldurchmesser werden bevorzugt als d₅₀-Werte angegeben.

Ermittelt werden können die Partikeldurchmesser generell mittels Laserbeugung, verbunden mit einer online Analyse. Zu diesem Zweck wird ein Laserstrahl in eine Partikelwolke gestrahlt, welche in einem durchsichtigen Gas, z. B. Luft verteilt ist. Die Partikel brechen das Licht, wobei kleine Partikel das Licht in einem größeren Winkel brechen als große Partikel. Der Streuwinkel steht somit in einem direkten Zusammenhang mit der Partikelgröße. mit abnehmender Partikelgröße nimmt der beobachtete Streuwinkel logarithmisch zu. Das gebrochene Licht wird durch eine Anzahl von Photodetektoren gemessen, die in verschiedenen Winkeln angebracht sind. Die Auswertung der Messungen erfolgen bevorzugt unter Nutzung der Lichtbeugungstheorie von Mie, die auf Maxwells Gleichung des elektromagnetischen Feldes beruht. Basis dieser Theorie sind zwei Annahmen. Einerseits wird angenommen, dass die zu vermessenden Partikel sphärisch sind, was aber nur für wenige Partikel wirklich zutrifft. Aus der gemessenen Laserbeugung wird das Volumen der Partikel berechnet. Andererseits wird von verdünnten Partikelsuspensionen ausgegangen. Genauer beschrieben wird das üblicherweise genutzte Verfahren zur Bestimmung von Partikelgrößen im Nanobereich durch dynamische Licht Streuung in der Broschüre "Dynamic Light Scattering: An Introduction in 30 Minutes", DLS technical note, MRK656-01 von Malvern Instruments Ltd.
Die Bestimmung der Partikelgröße im nanopartikulären Bereich kann auch mit Hilfe von Rasterelektronenmikroskopaufnahmen (REM-Aufnahmen) erfolgen. Zu diesem Zweck können partikelhaltige Emulsionen hergestellt werden, die in einem Spincoating-Verfahren in dünnster Schicht auf eine geeignete Oberfläche aufgebracht werden. Nach dem Verdunsten des Lösungsmittels werden REM-Aufnahmen gemacht und die erfassten Partikeldurchmesser vermessen. Durch statistische Auswertung wird der relative Partikeldurchmesser der vermessenen Probe ermittelt. Standardisierte Methoden zur Ermittlung Partikelgrößen und dafür geeignete Vorrichtungen sind in der ISO 13321, Methods for Determination of Particle Size Distribution Part 8: Photon correlation Spectroscopy, International Organisation for Standardisation [(ISO) 1996 (First Edition 1996-07-01)] erfasst und beschrieben, einschließlich Methoden zur Ermittlung von Größen im nm-Meßbereich.

Mögliche Verdickungsmittel, die zur Einstellung der Viskosität hinzugesetzt werden, sind vernetzte oder unvernetzte Homopolymere und Copolymere, basierend auf Monomereinheiten wie funktionalisierte Vinyleinheiten, z.B. Acrylsäure, Acrylate, Alkylmethacrylate (C₁₀-C₃₀) und Hydroxylalkylguar. Die Verdicker können einzeln und/oder in Kombinationen mit anderen Verdickern eingesetzt werden. Bevorzugt werden vernetzte Acrylsäurepolymere als Verdickungsmittel eingesetzt. Als geeignet für diesen Zweck haben sich das Natriumsalz der Carboxymethylcellulose (Finnfix®) und insbesondere vernetzte Acrylsäurehomopolymere (Carbomere®) erwiesen.

Der Anteil der Verdickungsmittel, der zur gezielten Einstellung des Viskositätsbereiches und zur Bildung einer druckfähigen oder dispensierfähigen Paste erforderlich ist, liegt im Bereich von 0,5 - 25 Gew.-%, bevorzugt 1 - 10 Gew.-%, bezogen auf die Gesamtmasse der Ätzpaste. Als besonders geeignet haben sich Zusammensetzungen erwiesen, in denen Verdickungsmittel in einer Menge von 1,5 - 6 Gew.-% enthalten sind.

Additive mit für den gewünschten Zweck vorteilhaften Eigenschaften sind Entschäumer, z.B. TEGO® Foamex N (Dimethylpolysiloxan), Thixotropiermittel z.B. BYK® 410 (modifizierter Harnstoff), Borchigel® Thixo2, Verlaufsmittel z.B. TEGO® Glide ZG 400 (Polyethersiloxan-Copolymer), Entlüfter z.B. TEGO® Airex 986 (Polymer mit Siliconspitze) und Haftvermittler z.B. Bayowet® FT 929 (Fluortensid). Diese können die Druck- und Dispensierfähigkeit der Ätzpaste positiv beeinflussen. Der Anteil der Additive liegt im Bereich von 0 - 2 Gew.- % bezogen auf die Gesamtmasse der Ätzpaste.

Durch Versuche wurde weiterhin gefunden, dass sowohl die Auswahl der zur Herstellung der Ätzmedien eingesetzten Komponenten als auch das Mengenverhältnis der Komponenten zueinander in den Ätzmedien von erheblicher Bedeutung ist. Je nachdem, in welcher Weise die Ätzmedien auf die zu ätzende Fläche aufgebracht werden, ist das prozentuale Verhältnis der Komponenten zueinander anders einzustellen, da u. a. Viskosität und Fließfähigkeit, bzw. die sich einstellende Thixotropie erheblich durch die enthaltenen Mengen an Lösungsmittel und an Verdickungsmittel beeinflusst werden. Die enthaltenen Mengen an Lösungs- und Verdickungsmittel wiederum beeinflussen das Ätzverhalten. Je nach Art der Verwendung im erfindungsgemäßen Verfahren ist es daher dem Fachmann möglich eine entsprechend angepasste Zusammensetzung des Ätzmediums auszuwählen.

Zur Herstellung der Ätzpasten werden die verschiedenen Komponenten nacheinander unter ausreichender Durchmischung miteinander vermischt und zwar derart, dass sich während der Zugabe der Ätzkomponente die Temperatur nur moderat erhöhen kann, sich aber während der Durchmischung eine Paste mit einer geeigneten Viskosität bildet.

Die erfindungsgemäßen Ätzpasten lassen sich in bekannter Weise auf die Waferoberflächen, bzw. Halbleiteroberflächen aufdrucken und lassen sich selbst im Feinliniendruck <50µm aufdrucken. Dieses ist beispielsweise möglich durch Verwendung eines geeigneten Siebes.

### Anwendungsgebiete

Angewendet werden können die erfindungsgemäßen Ätzpasten in der:
- Solarzellenindustrie
- Halbleiterindustrie
- Hochleistungselektronik

Die erfindungsgemäßen Ätzpasten können überall dort eingesetzt werden, wo eine ganzflächige und/oder strukturierte Ätzung von Siliziumoberflächen oder -schichten gewünscht wird. So können ganzflächig oder selektiv einzelne Strukturen in eine Siliziumoberfläche oder -schicht bis in die jeweils gewünschte Tiefe geätzt werden.

Anwendungsgebiete sind z.B.:
- sämtliche Ätzschritte (gleichbedeutend mit Strukturierungsschritten), inklusive Oberflächenreinigung/-aufrauhung an Siliziumoberflächen und -schichten, die zur Herstellung von optoelektrischen Bauelementen wie Solarzellen, Photodioden und dgl. führen, insbesondere betrifft dieses die Trennung des p-n-Übergangs in Siliziumsolarzellen und das partielle Entfernen dotierter Schichten (selektiver Emitter)
- sämtliche Ätzschritte an Siliziumoberflächen und -schichten, die zur Herstellung von Halbleiterbauelementen und Schaltkreisen führen
- sämtliche Ätzschritte an Siliziumoberflächen und -schichten, die zur Herstellung von Bauelementen der Hochleistungselektronik (IGBT's, Leistungs-Thyristoren, GTO's, etc.) führen.

Wie oben schon erwähnt, wurde überraschender Weise gefunden, dass durch Verwendung der erfindungsgemäßen alkalischen Ätzpasten, denen feinste, niedrigschmelzende organische Pulver zugesetzt werden, wesentlich präzisere Linien oder Strukturen mit einer erheblich verbesserten Kantenschärfe erhalten werden können. Gleichzeitig wurde gefunden, dass durch die Verwendung von NaOH und KOH im Gemisch als Ätzkomponenten sich die mittleren Ätzraten von oxidischen Oberflächen erheblich verbessern lassen, wodurch das Durchätzen von Siliziumverbindungen, wie z. b. Phosphat-Silikat-Glas im technischen Maßstab ermöglicht wird. Durch die verbesserten Eigenschaften und höheren Ätzraten sind die erfindungsgemäßen Ätzpasten nun auch im industriellen Herstellungsprozess mit hohen Durchsätzen von Halbleiterelementen einsetzbar.

Wie oben bereits erwähnt, haben Untersuchungen der Ätzpasten während und nach dem Ätzprozess unter Hitzeeinwirkung überraschender Weise gezeigt, dass die enthaltenen niedrigschmelzenden partikulären Zusätze beim Aufschmelzen sich nicht mit den übrigen Komponenten der Ätzpastenzusammensetzung vermischen sondern eine organische Phase bilden, die aufschwimmt und sich wie eine dünne Schicht auf die Oberfläche der aufgedruckten Ätzpaste legt. Die so gebildete Polymerschicht oder Polymermembran scheint offensichtlich einen erheblichen Einfluss auf das Verhalten der Ätzpaste und die Ätzrate zu haben, da die erfindungsgemäßen Zusammensetzungen über eine längere Zeit mit einer höheren Ätzrate wirksam sind als vergleichbare, bereits bekannte Zusammensetzungen, in denen partikelförmige Zusätze enthalten sind, die aber ihren Aggregatzustand bei Temperaturen oberhalb von 150 bzw. unterhalb von 200 °C nicht ändern. Darüber hinaus verhindert die Polymerschicht, dass dünne aufgedruckte Ätzpastenlinien während des Ätzens zerfließen und so zu breiteren Strukturen führen.

Die erfindungsgemäße Aufgabe wird also dadurch gelöst, dass alkalische Ätzpasten mit feinsten niedrigschmelzenden Polymerpartikeln versetzt werden. Bei Temperaturen leicht oberhalb der Schmelztemperatur bilden die aufgeschmolzenen Polymere auf der Oberfläche der aufgedruckten Linien oder Strukturen des Ätzmediums eine Polymermembran, durch die sowohl ein Verdunsten von Lösungsmittel aus der Ätzpaste als auch ein Zutritt von Feuchtigkeit unterbunden wird. Auf diese Weise bleibt die Ätzwirkung der nunmehr eingekapselten Ätzpaste erhalten. Überraschend ist es nun möglich geworden, mit diesen erfindungsgemäßen Ätzpastenzusammensetzungen schmale und tiefe, aber auch kompliziert verschlungene Ätzstrukturen in Oberflächen vom Solarzellen-Silizium sehr präzise auszubilden.

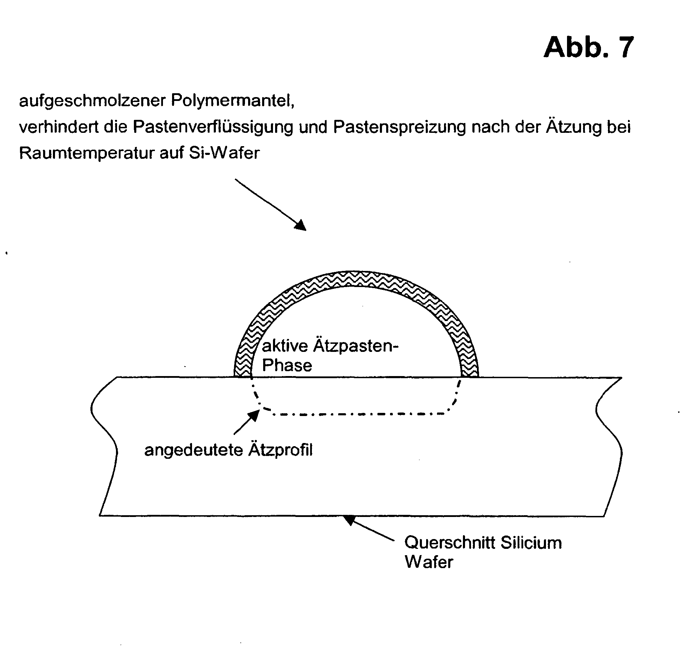

In Abbildung 7 ist eine schematische Darstellung des Verhaltens der niedrigschmelzenden Polymerpartikel beim Erhitzen und während des Ätzprozesses wiedergegeben. Während sich eine Polymermembran ausgebildet hat, kann die Ätzkomponente unter der darunter liegenden Fläche selektiv wirksam werden.

Wie oben schon festgestellt worden ist, führt die Erhitzung der mit den erfindungsgemäßen Ätzpasten bedruckten Wafer, bzw. Semiconductorelemente, auf Temperaturen über den Schmelzpunkt der enthaltenen Polymerpartikel nicht zu einer Verschlechterung des Ätzergebnisses, sondern zu einer erheblichen Verbesserung der Eigenschaften der geätzten Strukturen.

Zur Durchführung des Ätzverfahrens wird beispielsweise ein mit Ätzpaste bedruckter Wafer für 2 Minuten auf der Hotplate auf etwa 200 °C erhitzt. Diese Temperatur wird vorzugsweise dann gewählt, wenn die verwendeten Ätzpasten Polymerpartikel mit einer Schmelztemperatur von etwa 150 °C enthalten. Das Erhitzen auf diese Temperatur hat, wie oben bereits beschrieben, zur Folge, dass die Polymerpartikel aufschmelzen und eine zweite Phase auf der Paste auf der Pastenoberfläche bilden, eine sogenannte Polymermembran. Durch diese Polymermembran wird ein Verdampfen von Feuchtigkeit während des Ätzprozesses verhindert. Dadurch bleibt die Mobilität der enthaltene Ätzkomponente länger aufrechterhalten, so dass ein besseres Ätzverhalten erzielt werden kann.
Im allgemeinen wird also die Temperatur, auf die während der Einwirkzeit erhitzt wird, so eingestellt, dass die Polymerpartikel in kürzester Zeit aufschmelzen und sich möglichst schnell eine organische Schicht auf der Oberfläche der Ätzpaste ausbildet.

Im Anschluss an den eigentlichen Ätzschritt wird das geätzte Substrat wieder auf Raumtemperatur gebracht, wobei die über der Ätzpaste liegende Polymermembran erstarrt und eine Aufnahme von Feuchtigkeit durch die hygroskopische Ätzkomponente verhindert wird. Damit behält auch in dieser Phase die aufgedruckte Ätzpaste ihre Form und es erfolgt keine laterale Verbreiterung bzw. kein Runden der geätzten Struktur.

Während bei Verwendung bekannter alkalischer Ätzpasten im Falle von kantennahen Strukturierungsprozessen das Eindiffundieren von Luftfeuchtigkeit dazu führen kann, dass das Ätzmedium auf die gegenüberliegende Seite des Wafers wandert bzw. läuft, kann dieser Effekt bei Verwendung der erfindungsgemäßen Zusammensetzungen vollkommen unterbunden werden.

Durch die spezielle Zusammensetzung der erfindungsgemäßen Ätzpasten, worin NaOH und/oder KOH als Ätzkomponenten enthalten sein können, ist es möglich geworden, diese in Strukturierungsprozessen direkt vor der Eintauchen in ein HF-Bad einzusetzen, weil diese Zusammensetzungen Si-Schichten ebenso ätzen wie PSG (Phosphor-Silikat-Glas aus dem n-Dotierungsschritt). Auf diese Weise können vorteilhafter weise ein Waschschritt und ein Trocknungsschritt eingespart werden.

Da durch die Verwendung der erfindungsgemäßen Ätzpasten im Herstellungsprozess von Solarzellen verbesserte Ätzprofile mit besserer Flankensteilheit erzielt werden können, ist es auch möglich geworden, gewünschte Strukturen enger zu drucken und zu ätzen. Das heißt, es wird auf der Oberfläche der Solarzellen Platz gewonnen.

Die vorliegende Beschreibung ermöglicht es dem Fachmann die Erfindung umfassend anzuwenden. Bei etwaigen Unklarheiten versteht es sich von selbst, die zitierten Veröffentlichungen und Patentliteratur heranzuziehen. Dementsprechend gelten diese Dokumente als Teil der Offenbarung der vorliegenden Beschreibung.

Zum besseren Verständnis und zur Verdeutlichung der Erfindung werden im folgenden Beispiele gegeben, die im Rahmen des Schutzbereichs der vorliegenden Erfindung liegen. Diese Beispiele dienen auch zur Veranschaulichung möglicher Varianten. Aufgrund der allgemeinen Gültigkeit des beschriebenen Erfindungsprinzips sind die Beispiele jedoch nicht geeignet, den Schutzbereich der vorliegenden Anmeldung nur auf diese zu reduzieren.

Es versteht sich für den Fachmann von selbst, dass sich sowohl in den gegebenen Beispielen als auch in der übrigen Beschreibung die in den Pastenzusammensetzungen enthaltenen Komponentenmengen in der Summe immer nur zu 100 Gew.-% bezogen auf die Gesamtzusammensetzung aufaddieren und nicht darüber hinausgehen können, auch wenn sich aus den angegebenen Prozentbereichen höhere Werte ergeben könnten.

Die in den Beispielen und der Beschreibung sowie in den Ansprüchen gegebenen Temperaturen gelten immer in °C.

### Beispiele

### Beispiel 1

31g KOH
14g NaOH
60g Wasser
5g Ethylenglycolmonobutylether
3,5g Carbomer (Verdicker)
3g LD-PE Pulver (d50: <20um, Schmelzpunkt: 107°C)

Die Chemikalien werden in ein Becherglas eingewogen und mit einem Flügelrührer gemischt (2-4 Stunden Rührzeit) bis sich eine homogene, druckfähige Paste gebildet hat. Anschließend wird die Paste in eine PE-Dose abgefüllt.

Es erfolgt die Abfüllung in Behälter nach einer kurzen Standzeit.

Die vorliegende Zusammensetzung ergibt eine Ätzpaste, mit welcher gezielt z.B. Siliziumoberflächen und -schichten ganzflächig bzw. strukturiert unter Energieeintrag bis zu einer gewünschten Tiefe geätzt werden können. Durch Energieeintrag wird eine Temperatur höher 107°C einstellt, bevorzugt eine Temperatur von etwa 115°C.

Die Ätzpaste wird z.B. siebgedruckt bzw. mit einem Dispenser (z.B. Nadeldurchmesser von 260 µm) auf die Siliziumoberfläche aufgebracht und 3 min bei etwa 115°C auf einer Heizplatte geätzt. Bei der Erzeugung von Ätzstrukturen mit ca. 1 mm Linienbreite auf einem n-dotierten (100) Siliziumwafer beträgt die ermittelte Ätztiefe (in Abhängigkeit von Druck- und Dispensierparametern) 0,3 - 1 µm. Mit der Erhöhung der KOH-Konzentration und der Linienbreite kann die Ätztiefe gesteigert werden. Bei Linienbreiten von 4 mm und KOH-Konzentrationen von 20-50 Gew.-% betragen die Ätztiefen 2 - 3 µm.

Die erhaltene Ätzpaste ist lagerstabil, leicht zu handhaben und druckfähig. Sie kann mit einem Lösungsmittel, z.B. mit Wasser von der bedruckten Oberfläche oder Schicht bzw. vom Pastenträger (Sieb, Rakel, Schablone, Stempel, Klischee, Patrone usw.) entfernt werden.

### Beispiel 2

20 g KOH
62 g Wasser
1,5 g Polyethylenglycol 200
3,5 g Na-Salz der Carboxymethylcellulose (Finnfix Verdicker)
3,0 g HD-PE Pulver (d50: <25um, Schmelzpunkt: 134°C)

Der Ansatz und die Verarbeitung erfolgt wie in Beispiel 1 beschrieben.

Die Ätzpaste wird mit einem Dispenser (Nadeldurchmesser 450 µm) auf die Siliziumoberfläche aufgebracht und 3 min bei 145°C Ätztemperatur geätzt. Bei der Erzeugung von Ätzstrukturen mit ca. 1 mm Linienbreite auf einem n-dotierten (100) Siliziumwafer beträgt die ermittelte Ätztiefe (in Abhängigkeit von Druck- und Dispensierparametern) 0,2 - 1 µm.

### Beispiel 3

45g KOH
60g Wasser
8g Ethylenglycol
3,2g Carbomer (Verdicker)
3,5g PP Pulver (d50: <35um, Schmelzpunkt: 165°C)

Die Herstellung der Ätzpaste erfolgt wie in Beispiel 1 beschrieben worden ist.

Die Ätzpaste wird siebgedruckt bzw. mit einem Disperser (Nadeldurchmesser 450 µm) auf die Siliziumoberfläche aufgebracht und 3 min bei 180°C Ätztemperatur geätzt. Die ermittelte Ätztiefe beträgt bei Erzeugung von Ätzstrukturen mit 1 mm Linienbreite ca. 200 nm auf einem Siliziumwafer.

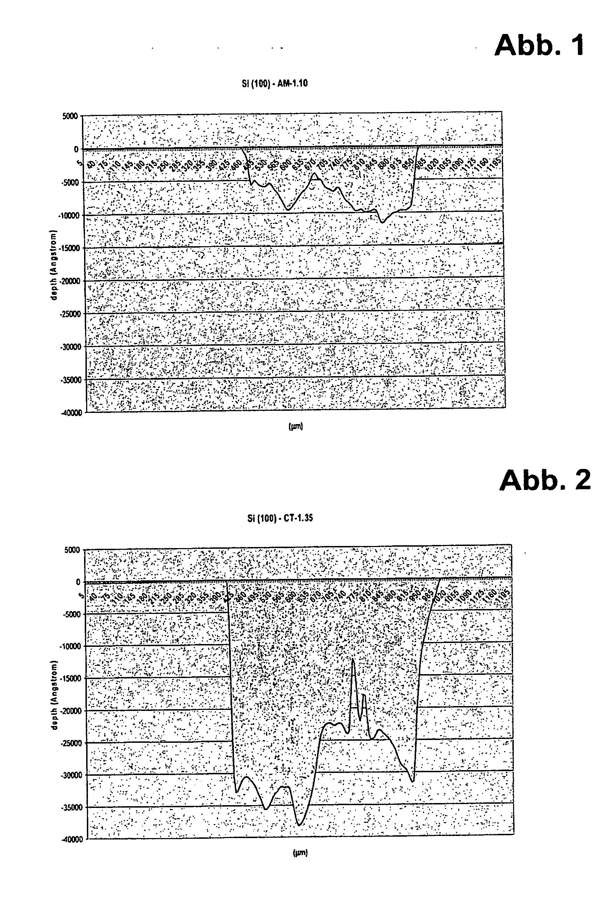

Die Abbildungen 1 und 2 zeigen den Vergleich der unter gleichen Bedingungen erzielbaren Ätztiefen in (100) Siliziumoberfläche mit den erfindungsgemäßen Ätzpasten und mit bisher bekannten Ätzpasten ohne Partikelzusatz.

### Beispiel 4

### Darstellung des Verhaltens der erfindungsgemäßen Ätzpasten

Die Pasten werden mittels Dispenser als Rahmen (sehr nahe zum Rand) auf die Siliciumwafer aufgetragen. Anschließend werden jeweils beide Wafer auf eine Hotplate bei 200°C für 2min gelegt. Hierbei wird das Silicium geätzt für die Kantenisolation (Trennung des p-n Übergangs).
Auf den folgenden Fotos wird eine Silicium Ätzpaste ohne Polymerzusatz mit einer Silicium-Ätzpaste mit niedrigschmelzenden Polymerzusatz verglichen (Schmelzpunkt < 160°C). Hierbei ist deutlich zu sehen, dass die Paste ohne Polymerzusatz wesentlich stärker verläuft (Oberflächenspreizung) auf der texturierten Silicium Oberfläche (die Paste hat keinen Schutzmantel gegen Luftfeuchtigkeit). Die Paste mit Polymeranteil zeigt dagegen auch 30min nach dem Ätzschritt auf der Heizplatte (2 min , 200 °C) keine wesentliche Oberflächenspreizung auf dem texturierten Silizium-Wafer.

Eine starke Oberflächenspreizung ist bei der Massenfertigung von Solarzellen nicht erwünscht!

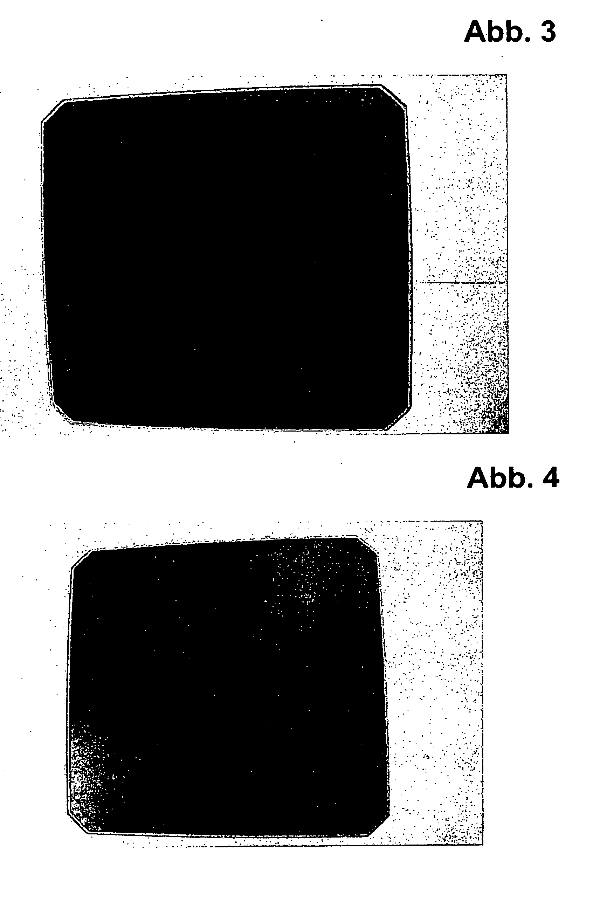

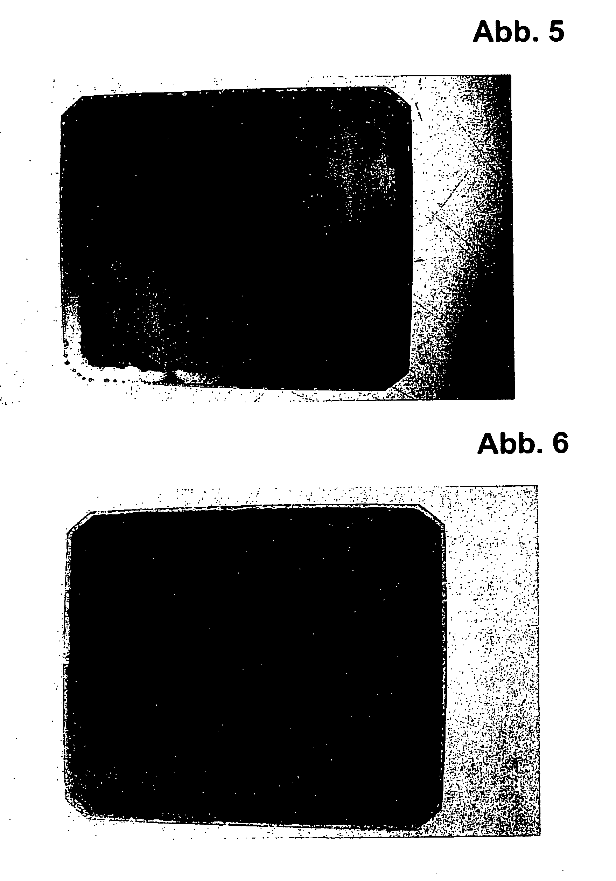

Durch die Abbildungen 3 bis 6 kann eindeutig das verbesserte Verhalten der erfindungsgemäßen Ätzpasten gezeigt werden im Vergleich zu bisher bekannten Ätzpasten ohne Partikelzusatz, und zwar hinsichtlich der präzisen Ätzung.

Die im folgenden gezeigten Abbildungen zeigen folgendes:
- **Abb. 1**: zeigt ein Ätzprofil, das unter Verwendung einer partikelfreien Ätzpaste in (100) Siliziumoberfläche erzeugt wird. Bei der Ätzpaste handelt es sich um die Ätzpaste: SolarEtch Si. Bei einer Ätzdauer von 2 min bei 200 °C wird eine Ätztiefe von ungefähr 1.0 µm und eine geätzte Linienbreite von ungefähr 500 µm erzeugt.
- **Abb. 2**: zeigt ein Ätzprofil, das unter Verwendung einer Ätzpaste, enthaltend niedrigschmelzende Polymerpartikel, in (100) Siliziumoberfläche erzeugt worden ist. Bei der Ätzpaste handelt es sich um eine erfindungsgemäße Ätzpaste mit niedrigschmelzenden Polymerpartikeln. Bei einer Ätzdauer von 2 min bei 200 °C wird eine Ätztiefe von ungefähr 3.0 µm und eine geätzte Linienbreite von 500 µm erzeugt.
- **Abb. 3**: zeigt einen Si-Wafer direkt nach dem Auftragen einer Ätzpaste ohne Polymerzusatz beim Ätzen auf der Heizplatte bei 200°C / 2 min. Es ist ein ebenmäßiges Druckbild zu sehen.
- **Abb. 4**: zeigt einen Si-Wafer direkt nach dem Auftragen einer Ätzpaste, enthaltend niedrigschmelzende Polymerpartikel, beim Ätzen auf der Heizplatte bei 200°C / 2 min. Es ist ein ebenmäßiges Druckbild zu sehen.
- **Abb. 5**: zeigt denselben Si-Wafer der vorherigen Abb. 3 30 min nach dem Ätzen unter Verwendung einer Ätzpaste ohne Polymer auf der Heizplatte bei 200°C / 2min. Die Ätzkanten sind ausgefranst.
- **Abb. 6**: zeigt denselben Si-Wafer der vorherigen Abb. 4 30 min nach dem Ätzen unter Verwendung einer Ätzpaste, enthaltend niedrigschmelzende Polymerpartikel, auf der Heizplatte bei 200°C / 2min. Die Ätzkanten sind ebenmäßig, so dass am Rand ein gerader Steg erhalten geblieben ist.
- **Abb. 7**: zeigt eine schematische Darstellung des Ätzprozesses mit alkalischer Ätzpaste, enthaltend niedrigschmelzende Polymerpartikel bei 200°C, wobei ein Querschnitt der Ätzpaste auf dem Siliciumsubstrat dargestellt ist.

## Patentansprüche

1. Verfahren zum Ätzen von Siliziumoberflächen und -schichten, oder von glasartigen Oberflächen, bestehend aus einem Siliziumderivat **dadurch gekennzeichnet, dass** eine druckbare, dispensierfähige, alkalischs Ätzpaste,
enthaltend
a) wenigstens eine basische Ätzkomponente,
b) mindestens ein Lösungsmittel
c) feinste organische Partikel mit niedrigem Schmelzpunkt und gegebenenfalls anorganische Partikel
d) gegebenenfalls Verdickungsmittel, und
e) gegebenenfalls Additive wie Entschäumer, Thixotropiermittel, Verlaufsmittel, Entlüfter, Haftvermittler,
selektiv auf die Oberfläche aufgebracht wird,
**dadurch gekennzeichnet, dass** während der Einwirkzeit die Ätzpaste auf eine Temperatur höher als 70°C, jedoch niedriger als 200 °C, erhitzt wird, wobei die in dem Ätzmedium enthaltenen Polymerpulver, ausgewählt aus der Gruppe der Polyethylen-, Polypropylen oder entsprechender Mischpulver, mit niedrigem Schmelzpunkt unterhalb von 150°C aufschmelzen und sich im geschmolzenen Zustand nicht mit den übrigen Komponenten der Ätzpaste mischen, sondern ein Zweiphasensystem bilden und auf dem Ätzmedium eine dünne Polymerschicht bilden.

2. Verfahren gemäß Anspruch 1, **dadurch gekennzeichnet, dass** die verwendete Ätzpaste als basische Ätzkomponente eine organische oder anorganische Base in einer Konzentration von 2 bis 50 Gew.-%, vorzugsweise 5 bis 48 Gew.-%; enthält bezogen auf die Gesamtmenge.

3. Verfahren gemäß Anspruch 1 oder 2, **dadurch gekennzeichnet, dass** die verwendete Ätzpaste als basische Ätzkomponente mindestens eine Ätzkomponente, ausgewählt aus der Gruppe Natriumhydroxid, Kaliumhydroxid, Ammoniak, Ethanolamin, Ethylendiamin und Tetraalkylammonium-hydroxid oder eines der Gemische Ethylendiamin/Brenzcatechin, und Ethanolamin/Gallussäure enthält.

4. Verfahren gemäß einem oder mehreren der Ansprüche 1 bis 3, **dadurch gekennzeichnet, dass** die verwendete Ätzpaste mindestens eine Ätzkomponente, ausgewählt aus der Gruppe Natriumhydroxid und Kaliumhydroxid enthält.

5. Verfahren gemäß einem oder mehreren der Ansprüche 1 bis 4, **Dadurch gekennzeichnet, dass** die verwendete Ätzpaste wenigstens ein Lösungsmittel ausgewählt aus der Gruppe Wasser, iso-Propanol, Diethylenglykol, Dipropylenglykol, Polyethylenglykole, 1,2-Propandiol, 1,4-Butandiol, 1,3-Butandiol, Glycerin, 1,5 Pentandiol, 2-Ethyl-1-hexanol oder deren Gemische, oder ausgewählt aus der Gruppe Acetophenon, Methyl-2-hexanon, 2-Octanon, 4-Hydroxy-4-methyl-2-pentanon, 1-Methyl-2-pyrrolidon, Ethylenglycolmonobutylether, Ethylenglycolmonomethylether, Triethylenglykolmonomethylether, Diethylenglykolmonobuthylether, Dipropylenglykolmonomethylether, Carbonsäureester wie [2,2-Butoxy-(Ethoxy)]-Ethylacetat, Propylencarbonat als solches oder im Gemisch in einer Menge von 10 bis 90 Gew.-%, vorzugsweise in einer Menge von 15 bis 85 Gew.-%, bezogen auf die Gesamtmenge des Mediums enthält.

6. Verfahren gemäß einem oder mehreren der Ansprüche 1 bis 5, **dadurch gekennzeichnet, dass** die verwendete Ätzpaste ein Verdickungsmittel ausgewählt aus der Gruppe Hydroxylalkylguar, Xanthan Gum, Cellulose und/oder Ethyl-, Hydroxylpropyl-, Hydroxylethylcellulose, Carboxymethylcellulose, Natrium-Carboxymethylhydroxylethylcellulose, Homopolymere oder Copolymere auf der Basis funktionalisierter Vinyleinheiten der Acrylsäure, Acrylate, und Alkylmethacrylate (C₁₀-C₃₀) einzeln oder im Gemisch in einer Menge von 0,5 bis 25 Gew.-%, vorzugsweise 1 bis 10 Gew.-%; bezogen auf die Gesamtmenge des Ätzmediums enthält.

7. Verfahren gemäß einem oder mehreren der Ansprüche 1 bis 6, **dadurch gekennzeichnet, dass** die verwendete Ätzpaste Additive, ausgewählt aus der Gruppe Entschäumer, Thixotropiermittel, Verlaufsmittel, Entlüfter, und Haftvermittler in einer Menge von 0 bis 2 Gew.-% bezogen auf die Gesamtmenge der Zusammensetzung enthält.

8. Verfahren gemäß einem oder mehreren der Ansprüche 1 bis 7, **dadurch gekennzeichnet, dass**
a) ein Ätzmedium ganzflächig oder gemäß einer Ätzstrukturvorlage gezielt nur an Stellen der Oberfläche, an denen eine Ätzung erwünscht ist, in Form von feinsten Linien im Feinliniendruck oder Strukturen aufgetragen wird,
b) das Ätzmedium auf die Oberfläche während einer Einwirkzeit von 30 s bis 5 min einwirkt bei einer Temperatur, welche etwas oberhalb des Schmelzpunkts der in der Ätzpaste enthaltenen Pulverpartikel liegt
und
c) das Ätzmedium nach erfolgter Ätzung mit einem Lösungsmittel oder einem Lösungsmittelgemisch oder durch Hitzeeinwirkung wieder entfernt wird.

9. Verfahren gemäß Anspruch 8, **dadurch gekennzeichnet, dass** das Ätzmedium durch Energieeintrag aktiviert wird und bei einer Temperatur höher als 80 °C, vorzugsweise niedriger als 200 °C einwirkt.

10. Verfahren gemäß einem oder mehreren der Ansprüche 8 oder 9, **dadurch gekennzeichnet, dass** das Ätzmedium durch Wärmeeinwirkung (IR-Lampe, Heizplatte) aktiviert wird.

11. Verfahren gemäß einem oder mehreren der Ansprüche 8 bis 10, **dadurch gekennzeichnet, dass** das Ätzmedium durch ein Sieb-, Schablonen-, Tampon-, Stempel-, Ink-Jet- oder manuelles Druckverfahren oder in einer Dispensiertechnik auf die zu ätzende Oberfläche aufgebracht wird.

12. Anwendung des Verfahrens nach einem oder mehreren der Ansprüche 1 bis 11 in der Photovoltaik, Halbleitertechnik, Hochleistungselektronik, Displayherstellung sowie zur Herstellung von Photodioden, Schaltkreisen und elektronischen Bauelementen unter Verwendung eines Ätzmediums.

13. Verfahren nach einem oder mehreren der Ansprüche 1 bis 11, worin ein Ätzmedium zum Ätzen von Siliziumoberflächen und -schichten zur Trennung des p-n Übergangs in Solarzellen eingesetzt wird.

14. Verfahren nach einem oder mehreren der Ansprüche 1 bis 11, worin ein Ätzmedium zum Ätzen von Siliziumoberflächen und -schichten eingesetzt wird zur Herstellung eines selektiven Emitters für Solarzellen.

15. Verfahren nach einem oder mehreren der Ansprüche 1 bis 11, worin ein Ätzmedium zum Ätzen von Siliziumoberflächen und -schichten von Solarzellen zur Verbesserung des Antireflexionsverhaltens eingesetzt wird.

16. Verfahren nach einem oder mehreren der Ansprüche 1 bis 11, worin ein Ätzmedium zum Ätzen von Siliziumoberflächen und -schichten zur Herstellung von Halbleiterbauelementen und deren Schaltkreisen eingesetzt wird.

17. Verfahren nach einem oder mehreren der Ansprüche 1 bis 11, worin ein Ätzmedium zum Ätzen von Siliziumoberflächen und -schichten zur Herstellung von Bauelementen der Hochleistungselektronik eingesetzt wird.

## Claims

1. Process for etching silicon surfaces and layers, or glass-like surfaces, consisting of a silicon derivative, **characterised in that** a printable, dispensable, alkaline etching paste,
comprising
a) at least one basic etching component,
b) at least one solvent,
c) extremely fine organic particles having a low melting point and optionally inorganic particles,
d) optionally thickening agents, and
e) optionally additives, such as antifoams, thixotropic agents, flow-control agents, deaerators, adhesion promoters,
is applied selectively to the surface,
**characterised in that**, during the exposure time, the etching paste is heated to a temperature higher than 70°C, but lower than 200°C, where the polymer powders, selected from the group of polyethylene, polypropylene or corresponding mixed powders, having a low melting point present in the etching medium melt below 150°C and, in the molten state, do not mix with the other components of the etching paste, but instead form a two-phase system and form a thin polymer layer on the etching medium.

2. Process according to Claim 1, **characterised in that** the etching paste used comprises, as basic etching component, an organic or inorganic base in a concentration of 2 to 50% by weight, preferably 5 to 48% by weight; based on the total amount.

3. Process according to Claim 1 or 2, **characterised in that** the etching paste used comprises, as basic etching component, at least one etching component selected from the group sodium hydroxide, potassium hydroxide, ammonia, ethanolamine, ethylenediamine and tetraalkylammonium hydroxide or one of the mixtures ethylenediamine/pyrocatechol and ethanolamine/gallic acid.

4. Process according to one or more of Claims 1 to 3, **characterised in that** the etching paste used comprises at least one etching component selected from the group sodium hydroxide and potassium hydroxide.

5. Process according to one or more of Claims 1 to 4, **characterised in that** the etching paste used comprises at least one solvent selected from the group water, isopropanol, diethylene glycol, dipropylene glycol, polyethylene glycols, 1,2-propanediol, 1,4-butanediol, 1,3-butanediol, glycerol, 1,5-pentanediol, 2-ethyl-1-hexanol or mixtures thereof, or selected from the group acetophenone, methyl-2-hexanone, 2-octanone, 4-hydroxy-4-methyl-2-pentanone, 1-methyl-2-pyrrolidone, ethylene glycol monobutyl ether, ethylene glycol monomethyl ether, triethylene glycol monomethyl ether, diethylene glycol monobutyl ether, dipropylene glycol monomethyl ether, carboxylic acid esters, such as [2,2-butoxy(ethoxy)]ethyl acetate, propylene carbonate, as such or in a mixture in an amount of 10 to 90% by weight, preferably in an amount of 15 to 85% by weight, based on the total amount of the medium.

6. Process according to one or more of Claims 1 to 5, **characterised in that** the etching paste used comprises a thickening agent selected from the group hydroxyalkylguar, xanthan gum, cellulose and/or ethyl-, hydroxypropyl-, hydroxyethylcellulose, carboxymethylcellulose, sodium carboxymethylhydroxyethylcellulose, homopolymers or copolymers based on functionalised vinyl units of acrylic acid, acrylates and alkyl methacrylates (C₁₀-C₃₀), individually or in a mixture in an amount of 0.5 to 25% by weight, preferably 1 to 10% by weight; based on the total amount of the etching medium.

7. Process according to one or more of Claims 1 to 6, **characterised in that** the etching paste used comprises additives selected from the group antifoams, thixotropic agents, flow-control agents, deaerators and adhesion promoters in an amount of 0 to 2% by weight, based on the total amount of the composition.

8. Process according to one or more of Claims 1 to 7, **characterised in that**
a) an etching medium is applied over the entire surface or in accordance with an etch structure mask specifically only to areas of the surface at which etching is desired, in the form of extremely fine lines in fine line printing or structures,
b) the etching medium acts on the surface during an exposure time of 30 s to 5 min at a temperature which is somewhat above the melting point of the powder particles present in the etching paste,
and
c) the etching medium is removed again after the etching is complete using a solvent or solvent mixture or by the action of heat.

9. Process according to Claim 8, **characterised in that** the etching medium is activated by input of energy and acts at a temperature higher than 80°C, preferably lower than 200°C.

10. Process according to one or more of Claims 8 or 9, **characterised in that** the etching medium is activated by the action of heat (IR lamp, hotplate).

11. Process according to one or more of Claims 8 to 10, **characterised in that** the etching medium is applied to the surface to be etched by a screen, template, pad, stamp, ink-jet or manual printing process or in a dispensing technique.

12. Use of the process according to one or more of Claims 1 to 11 in photovoltaics, semiconductor technology, high-performance electronics, display manufacture and for the production of photodiodes, circuits and electronic components using an etching medium.

13. Process according to one or more of Claims 1 to 11, in which an etching medium is employed for the etching of silicon surfaces and layers in order to part the p-n junction in solar cells.

14. Process according to one or more of Claims 1 to 11, in which an etching medium is employed for the etching of silicon surfaces and layers for the production of a selective emitter for solar cells.

15. Process according to one or more of Claims 1 to 11, in which an etching medium is employed for the etching of silicon surfaces and layers of solar cells in order to improve the antireflection behaviour.

16. Process according to one or more of Claims 1 to 11, in which an etching medium is employed for the etching of silicon surfaces and layers for the production of semiconductor components and circuits thereof.

17. Process according to one or more of Claims 1 to 11, in which an etching medium is employed for the etching of silicon surfaces and layers for the production of components in high-performance electronics.

## Revendications

1. Procédé de gravure de surfaces et couches en silicium, ou de surfaces similaires à du verre, constituées par un dérivé de silicium, **caractérisé en ce qu'**une pâte de gravure alcaline, imprimable et distribuable,
comprenant
a) au moins un composant de gravure de base,
b) au moins un solvant,
c) des particules organiques extrêmement fines présentant un point de fusion bas
et en option, des particules inorganiques,
d) en option, des agents épaississants, et
e) en option, des additifs tels que des anti-mousse, des agents thixotropiques, des agents de contrôle de flux, des désaérateurs, des stimulateurs d'adhérence,
est appliquée de façon sélective sur la surface,
**caractérisé en ce que**, pendant le temps d'exposition, la pâte de gravure est chauffée jusqu'à une température supérieure à 70°C mais inférieure à 200°C, où les poudres de polymères, choisies parmi le groupe constitué par des poudres de polyéthylène, de polypropylène ou mixtes correspondantes, présentant un point de fusion bas présentes dans le milieu de gravure sont fondues au dessous de 150°C et, dans l'état fondu, ne se mélangent pas avec les autres composants de la pâte de gravure mais en lieu et place, forment un système à deux phases et forment une couche mince en polymères sur le milieu de gravure.

2. Procédé selon la revendication 1, **caractérisé en ce que** la pâte de gravure utilisée comprend, en tant que composant de gravure de base, une base organique ou inorganique selon une concentration de 2 à 50% en poids, de façon préférable de 5 à 48% en poids, sur la base de la quantité totale.

3. Procédé selon la revendication 1 ou 2, **caractérisé en ce que** la pâte de gravure utilisée comprend, en tant que composant de gravure de base, au moins un composant de gravure choisi parmi le groupe constitué par hydroxyde de sodium, hydroxyde de potassium, ammoniac, éthanolamine, éthylènediamine et hydroxyde de tétraalkylammonium ou l'un des mélanges éthylènediamine/pyrocatéchol et éthanolamine/acide gallique.

4. Procédé selon une ou plusieurs des revendications 1 à 3, **caractérisé en ce que** la pâte de gravure utilisée comprend au moins un composant de gravure choisi parmi le groupe constitué par hydroxyde de sodium et hydroxyde de potassium.

5. Procédé selon une ou plusieurs des revendications 1 à 4, **caractérisé en ce que** la pâte de gravure utilisée comprend au moins un solvant choisi parmi le groupe constitué par eau, isopropanol, diéthylène glycol, dipropylène glycol, polyéthylène glycols, 1,2-propanediol, 1,4-butanediol, 1,3-butanediol, glycérol, 1,5-pentanediol, 2-éthyl-1-hexanol ou des mélanges afférents, ou choisi parmi le groupe constitué par acétophénone, méthyl-2-hexanone, 2-octanone, 4-hydroxy-4-méthyl-2-pentanone, 1-méthyl-2-pyrrolidone, l'éther monobutylique d'éthylène glycol, l'éther monométhylique d'éthylène glycol, l'éther monométhylique de triéthylène glycol, l'éther monobutylique de diéthylène glycol, l'éther monométhylique de dipropylène glycol, des esters d'acide carboxylique, tels que l'acétate de [2,2-butoxy(éthoxy)]éthyle, carbonate de propylène, tel quel ou en mélange selon une quantité de 10 à 90% en poids, de façon préférable selon une quantité de 15 à 85% en poids, sur la base de la quantité totale du milieu.

6. Procédé selon une ou plusieurs des revendications 1 à 5, **caractérisé en ce que** la pâte de gravure utilisée comprend un agent épaississant choisi parmi le groupe constitué par hydroxyalkylguar, gomme de xanthane, cellulose et/ou éthylcellulose, hydroxypropylcellulose, hydroxyéthylcellulose, carboxyméthylcellulose, carboxyméthylhydroxyéthylcellulose de sodium, des homopolymères ou des copolymères basés sur des unités de vinyle fonctionnalisées d'acide acrylique, des acrylates, et des méthacrylates d'alkyle (C₁₀-C₃₀), individuellement ou en mélange selon une quantité de 0,5 à 25% en poids, de façon préférable de 1 à 10% en poids, sur la base de la quantité totale du milieu de gravure.

7. Procédé selon une ou plusieurs des revendications 1 à 6, **caractérisé en ce que** la pâte de gravure utilisée comprend des additifs choisis parmi le groupe constitué par des anti-mousse, des agents thixotropiques, des agents de contrôle de flux, des désaérateurs et des stimulateurs d'adhérence selon une quantité de 0 à 2% en poids, sur la base de la quantité totale de la composition.

8. Procédé selon une ou plusieurs des revendications 1 à 7, **caractérisé en ce que** :
a) un milieu de gravure est appliqué sur la totalité de la surface ou conformément à un masque de structure de gravure de façon spécifique seulement sur des zones de la surface au niveau desquelles une gravure est souhaitée, sous la forme de lignes extrêmement fines selon une impression ou des structures en lignes fines,
b) le milieu de gravure agit sur la surface pendant un temps d'exposition de 30 s à 5 min à une température qui est quelque peu au delà du point de fusion des particules pulvérulentes présentes dans la pâte de gravure,
et
c) le milieu de gravure est enlevé à nouveau après que la gravure est terminée en utilisant un solvant ou un mélange de solvants ou au moyen de l'action de la chaleur.

9. Procédé selon la revendication 8, **caractérisé en ce que** le milieu de gravure est activé au moyen d'une entrée d'énergie et agit à une température supérieure à 80°C, de façon préférable inférieure à 200°C.

10. Procédé selon une ou plusieurs des revendications 8 et 9, **caractérisé en ce que** le milieu de gravure est activé au moyen de l'action de chaleur (lampe IR, plaque chaude).

11. Procédé selon une ou plusieurs des revendications 8 à 10, **caractérisé en ce que** le milieu de gravure est appliqué sur la surface destinée à être gravée au moyen d'un procédé d'impression par sérigraphie, par gabarit, par patin, par timbre, par jet d'encre ou manuelle ou selon une technique par délivrance.

12. Utilisation du procédé selon une ou plusieurs des revendications 1 à 11 au niveau des techniques photovoltaïques, de la technologie des semiconducteurs, des dispositifs électroniques haute performance, de la fabrication d'affichages et pour la production de photodiodes, de circuits et composants électroniques en utilisant un milieu de gravure.

13. Procédé selon une ou plusieurs des revendications 1 à 11, dans lequel un milieu de gravure est utilisé pour graver des surfaces et couches en silicium afin de conformer la jonction p-n dans des cellules solaires.

14. Procédé selon une ou plusieurs des revendications 1 à 11, dans lequel un milieu de gravure est utilisé pour graver des surfaces et couches en silicium pour la production d'un émetteur sélectif pour des cellules solaires.

15. Procédé selon une ou plusieurs des revendications 1 à 11, dans lequel un milieu de gravure est utilisé pour graver des surfaces et couches en silicium afin d'améliorer le comportement antireflet.

16. Procédé selon une ou plusieurs des revendications 1 à 11, dans lequel un milieu de gravure est utilisé pour graver des surfaces et couches en silicium pour la production de composants semiconducteurs et de circuits afférents.

17. Procédé selon une ou plusieurs des revendications 1 à 11, dans lequel un milieu de gravure est utilisé pour graver des surfaces et couches en silicium pour la production de composants dans des dispositifs électroniques haute performance.
